# EUROPEAN PATENT APPLICATION

(11) **EP 4 683 454 A1**
(43) Date of publication of application: **21.01.2026**
(21) Application number: 24214385.7
(22) Date of filing: 21.11.2024
(51) Int. Cl.: H10D 10/01, H10D 10/80, H10D 62/13, H10D 62/822

(54) **VERTICAL HETEROJUNCTION BIPOLAR TRANSISTOR WITH LATERALLY RECESSED COLLECTOR AND A SEMICONDUCTOR LINER ON SIDEWALLS OF THE COLLECTOR**

(30) Priority: 16.07.2024 US 202418774252
(71) Applicant: GlobalFoundries U.S. Inc., Malta, NY 12020 (US)
(72) Inventor: KENNEY, Crystal Rose, Malta, NY, 12020 (US); JAIN, Vibhor, Essex Junction, VT, 05452 (US); PEKARIK, John J., Essex Junction, VT, 05452 (US); HOLT, Judson Robert, Malta, NY, 12020 (US); DERRICKSON, Alexander M., Malta, NY, 12020 (US); NAFARI, Mona, Malta, NY, 12020 (US)
(74) Representative: Lambacher, Michael

(57) **Abstract**

The present disclosure relates to semiconductor structures and, more particularly, to vertical heterojunction bipolar transistors (HBTs) and methods of manufacture. The structure includes: a collector mesa region (20) above a semiconductor substrate (22) comprising a subcollector (24); a base mesa region (18) above the collector region (20); an emitter region (26) on the base region; and a recess (14) underneath the base (18), above the semiconductor substrate (22, 24) and adjacent to the collector region (20). The recess may form an airgap or be filled with a dielectric material. The sidewalls of the collector (20), the lower surface of the base (18) and the upper surface of the subcollector (24) are lined with a semiconductor (16a, 16b, 16c). Preferably the collector is made of silicon and the liner of silicon-germanium.

## Description

### BACKGROUND

This invention was made with government support under Contract # HR0011-20-3-0002 awarded by DARPA-T-MUSIC. The government has certain rights in the invention.

The present disclosure relates to semiconductor structures and, more particularly, to vertical heterojunction bipolar transistors and methods of manufacture.

A heterojunction bipolar transistor is a type of bipolar junction transistor which uses differing semiconductor materials for the emitter and base regions, creating a heterojunction. The heterojunction bipolar transistor can handle signals of very high frequencies, up to several hundred GHz. The heterojunction bipolar transistor may be used in modern ultrafast circuits including radio frequency (RF) systems, and in applications requiring a high power efficiency, such as RF power amplifiers in cellular telephones.

### SUMMARY

In an aspect of the disclosure, a structure comprises: a collector region above a semiconductor substrate; a base region above the collector region; an emitter region adjacent to the base region; and an undercut structure above the semiconductor substrate and adjacent to the collector region.
Additional features of the structure are set forth in dependent claims 2 to 9.

In an aspect of the disclosure, a structure comprises: a heterojunction bipolar transistor comprising a base region, a collector region, a sub-collector region and an emitter region; and an undercut region bounded on a lateral surface and a vertical surface by the base region, and semiconductor material lining vertical sidewalls of the collector region and of the sub-collector region.
Additional features of the structure are set forth in dependent claims 11 to 14.

In an aspect of the disclosure, a method comprises: forming a collector region above a semiconductor substrate; forming a base region above the collector region; forming an emitter region adjacent to the base region; and forming an undercut structure above the semiconductor substrate and adjacent to the collector region.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows a structure and respective fabrication processes in accordance with aspects of the present disclosure.
FIGS. 2-7 show different structures and respective fabrication processes in accordance with additional aspects of the present disclosure.
FIGS. 8A-8L show fabrication processes of a structure in accordance with aspects of the present disclosure.

### DETAILED DESCRIPTION

The present disclosure relates to semiconductor structures and, more particularly, to vertical heterojunction bipolar transistors and methods of manufacture. More specifically, the present disclosure is directed to a vertical heterojunction bipolar transistor with an undercut (e.g., undercut profile) in the collector region. The vertical heterojunction bipolar transistor may also include an emitter region and a base region with different undercut (e.g., recess) configurations adjacent to the collector region. Advantageously, the present disclosure provides the ability to fabricate an undercut structure to achieve a high performance device, e.g., improved Ccb, in addition to providing improved cross wafer process variations.

In more specific embodiments, the bipolar transistor comprises an emitter region, a base region and a collector region arranged in a vertical orientation, with the collector extending laterally beyond the emitter region. The collector region may be, for example, single crystal semiconductor material, e.g., single crystalline SiP material. An undercut or recess (hereinafter referred to as an undercut) extends on sides of the collector region, with the undercut filled with insulator material or devoid of any fill material thereby resulting in an airgap. In embodiments, the undercut may be laterally and vertically bounded by single crystal semiconductor material that is selective to the semiconductor material of the collector region. For example, the undercut may be laterally and vertically bounded by SiGe material of different dopant types, which can also bound the collector region. In embodiments, for example, the collector region comprises SiP material bounded by SiGe or SiGeP or SiGeB material. In further embodiments, the collector region and undercut region may be different configurations.

The vertical heterojunction bipolar transistors of the present disclosure can be manufactured in a number of ways using a number of different tools. In general, though, the methodologies and tools are used to form structures with dimensions in the micrometer and nanometer scale. The methodologies, i.e., technologies, employed to manufacture the vertical heterojunction bipolar transistor of the present disclosure have been adopted from integrated circuit (IC) technology. For example, the structures are built on wafers and are realized in films of material patterned by photolithographic processes on the top of a wafer. In particular, the fabrication of the vertical heterojunction bipolar transistors uses three basic building blocks: (i) deposition or growth of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

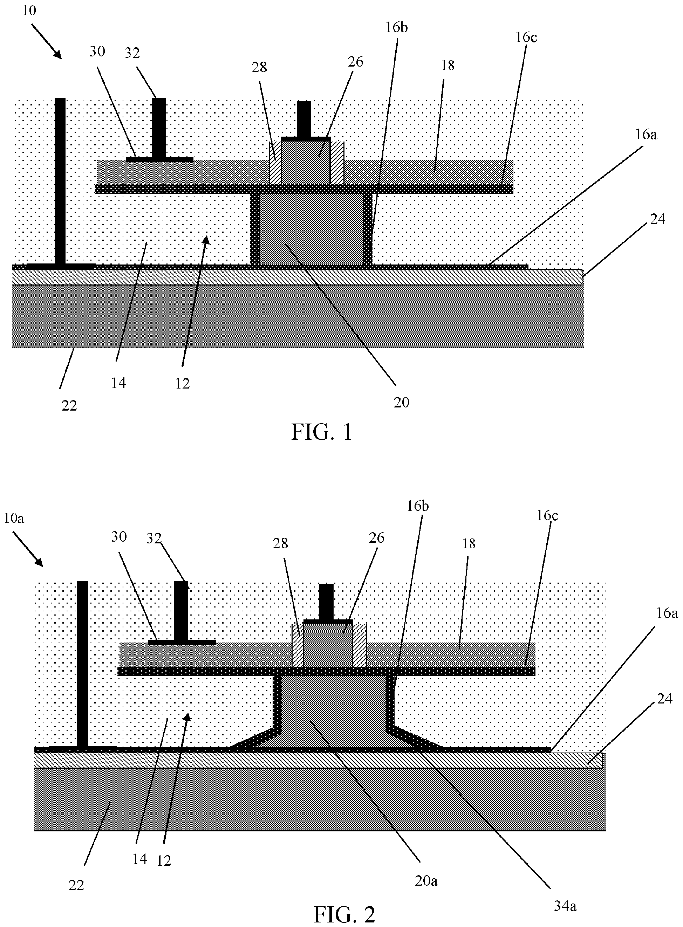

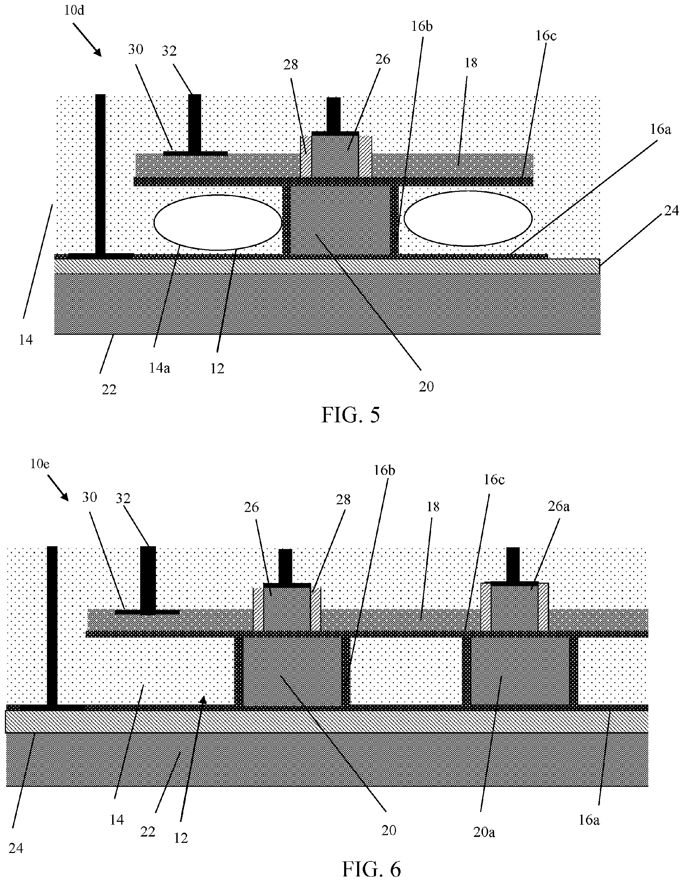

FIG. 1 shows a structure and respective fabrication processes in accordance with aspects of the present disclosure. In particular, the structure 10 of FIG. 1 may be a vertical heterojunction bipolar transistor with an undercut region 12 filled with insulator material 14 and which is bounded laterally and vertically by semiconductor material 16a, 16b, 16c. In embodiments, the undercut region 12 may be provided in a collector region 20, which comprises semiconductor material that is different than semiconductor material of the intrinsic base region, e.g., semiconductor material 16c, in addition to different material than the semiconductor materials 16b, 16c. In embodiments, the semiconductor material 16c may comprise single crystalline SiGeB or SiB, with additional semiconductor material forming an extrinsic base region 18 comprising single crystalline SiGeB or SiB material or combinations thereof over the intrinsic base region 16c. In embodiments, the Ge% material of the base regions 16c, 18 may have a uniform concentration (e.g., same material composition). In embodiments, the insulator material 14 may be silicon dioxide or other interlevel dielectric or insulator material such as, for example, a flowable oxide such as tetraethoxysilane (TEOS). In further embodiments, the insulator material 14 may equally represent an airgap or cavity below the intrinsic base region 16c as shown in FIG. 5.

In more specific embodiments, the structure 10 of FIG. 1 includes a sub-collector region 24 formed in a semiconductor substrate 22. In embodiments, the semiconductor material 16a may also form part of the sub-collector region. The semiconductor substrate 22 may be single crystalline semiconductor material, e.g., Si, with a suitable crystallographic orientation (e.g., a (100), (110), (111), or (001) crystallographic orientation). As should be understood by those of skill in the art, the semiconductor substrate 22 may be a P-type semiconductor substrate as is known in the art such that no further explanation is required for a complete understanding of the present invention. The semiconductor substrate 22 may either be a bulk semiconductor material or, alternatively, a semiconductor-on-insulator substrate formed by any suitable process, such as separation by implantation of oxygen (SIMOX), oxidation, deposition, and/or other suitable process.

The sub-collector region 24 may be formed in the semiconductor substrate 22 by an ion implantation process with an N+ type dopant. In embodiments, the N+ type dopant may be, for example, Arsenic (As), Phosphorus (P) and Antimony (Sb), among other suitable examples. In preferred embodiments, the sub-collector region 24 may be SiP. The ion implantation process may use a patterned implantation mask to define selected areas exposed for the implantation. The implantation mask may include a layer of a light-sensitive material, such as an organic photoresist, applied by a spin coating process, prebaked, exposed to light projected through a photomask, baked after exposure, and developed with a chemical developer. The implantation mask has a thickness and stopping power sufficient to block masked areas against receiving a dose of the implanted ions. An annealing process may be used to drive the dopant into the semiconductor substate 22.

FIG. 1 further shows the semiconductor material 16a on a surface of the sub-collector region 24. In embodiment, the semiconductor material 16a may be part of the sub-collector region. Moreover, the semiconductor material 16b may be provided on the vertical sidewalls of the collector region 20 and the semiconductor material 16c may be provided on a top of the collector region 20. In embodiments, the semiconductor material 16c may act as the intrinsic base region. Accordingly, the collector region 20 is completely bounded or encapsulated on all sides by the semiconductor material 16a, 16b, 16c, with the semiconductor material 16c forming the intrinsic base region.

In embodiments, the semiconductor material 16a, 16b, 16c may be a semiconductor material that is selective to the semiconductor material of the collector region 20. For example, the semiconductor material 16a may be SiGe doped with an N+ type dopant, e.g., Arsenic (As), Phosphorus (P) and Antimony (Sb). In more specific embodiments, the semiconductor material 16 may be SiGeP formed by an epitaxial process with an in-situ dopant. The semiconductor material 16b may be SiGe or SiGeP or SiC; whereas the semiconductor material 16c (forming the intrinsic base) may be SiGeB. It should also be understood that any of the n-doped semiconductor materials may be Arsenic (As), Phosphorus (P) or Antimony (Sb).

The collector region 20 may be formed over the sub-collector region 24 and, more specifically, over the semiconductor material 16a. In embodiments, the collector region 20 may be single crystalline Si material doped with an N+ type dopant, e.g., Arsenic (As), Phosphorus (P) and Antimony (Sb). In more specific embodiments, the collector region 20 may be SiP. The collector region 20 may be formed by an epitaxial growth process as described in more detail herein.

The collector region 20 may be lined on all sides with the semiconductor materials 16a, 16b, 16c. In embodiments and as already disclosed herein, the semiconductor materials 16a, 16b, 16c may be different semiconductor material than the semiconductor material of the collector region 20. For example, collector region 20 may be single crystalline Si doped with an N+ type dopant, e.g., Arsenic (As), Phosphorus (P) and Antimony (Sb). The intrinsic base region 16c above the collector region 20 may be composed of Si or SiGe doped with a P+ type dopant, e.g., SiB or SiGeB. The extrinsic base region 18 above semiconductor material 16c of the intrinsic base region may also be SiB or SiGeB or combinations thereof. The SiGe material and Si material may be single crystalline semiconductor material.

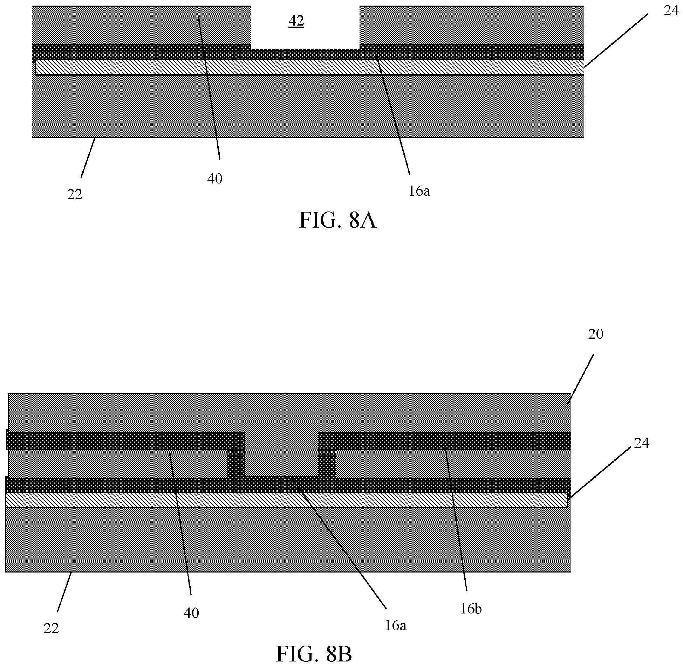

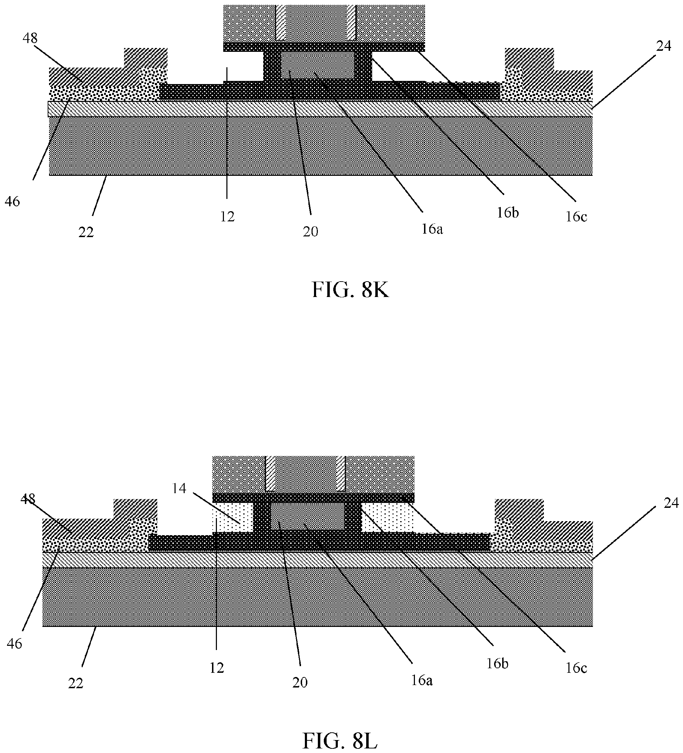

As described in more detail with respect to FIGS 8A-8L, the undercut 12 may be formed about the collector region 20, below the base regions 16c, 18 and above the sub-collector region 24 (and semiconductor material 16a). The undercut 12 may be completely or partially filled with insulator material 14. In embodiments, the insulator material 14 may be laterally and vertically bounded by the semiconductor materials 16a, 16b, 16c. For example, the insulator material 14 may be vertically may be bounded by semiconductor material 16b on the vertical sidewalls of the collector region 20, and laterally bounded by the semiconductor material 16a above the sub-collector region 24 and the semiconductor material 16c above the collector region 20. In embodiments, the insulator material 14 may be silicon dioxide or other insulator materials such as silicon nitride, or TEOS, etc.

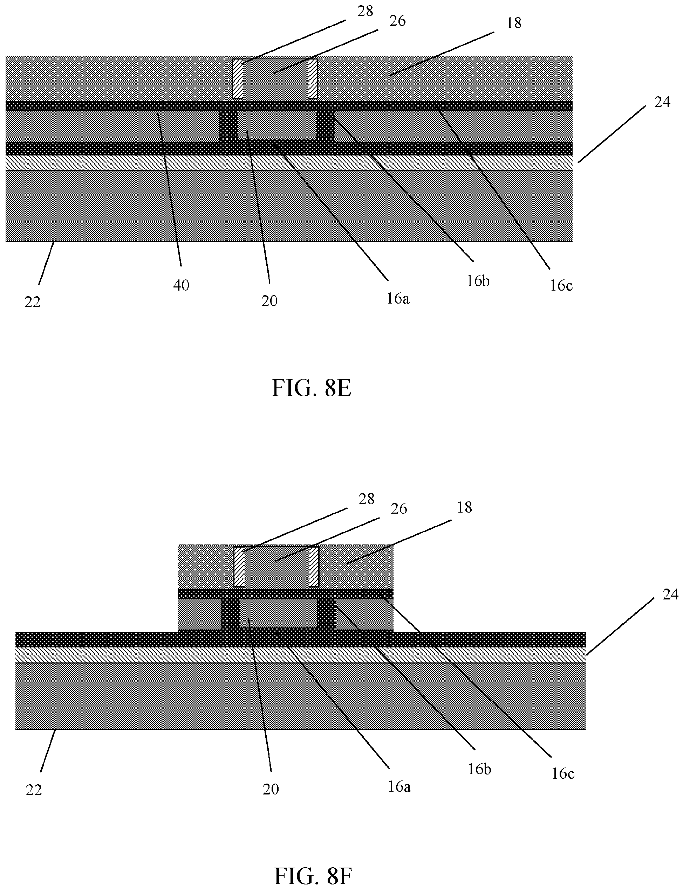

The semiconductor material 16c of the intrinsic base region may be above and in direct physical contact with the collector region 20 and the insulator material 14. The semiconductor material 16c of the intrinsic base region may be SiGe material and more specifically, p-type single crystalline SiGe material, e.g., SiGeB. The semiconductor material 16c of the intrinsic base region may be formed by epitaxial growth process with a p-type in-situ doping process as described in more detail with respect to FIG. 8E.

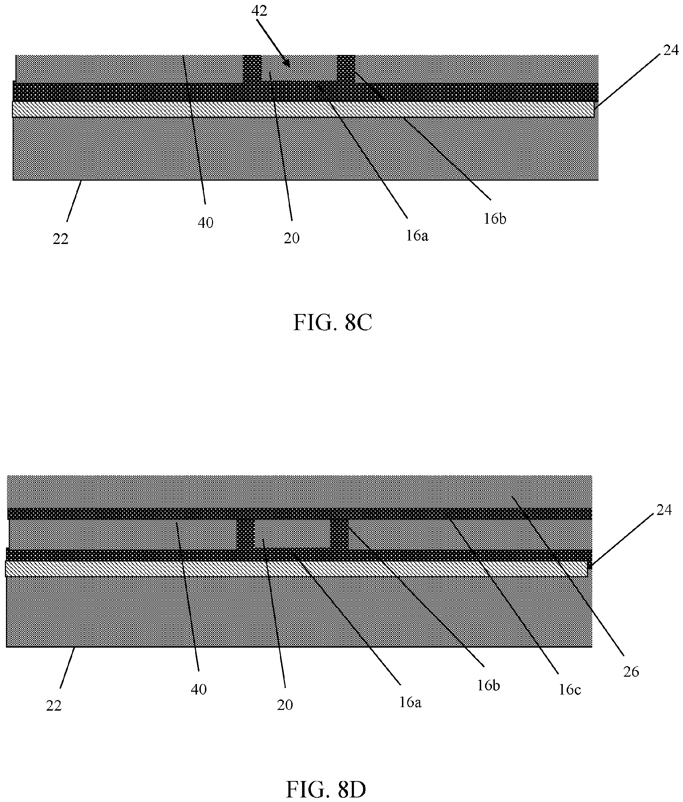

The extrinsic base 18 may be formed over the base region 16c and the undercut 12. The extrinsic base 18 may be formed by an epitaxial growth process with an in-situ doping, e.g., p-type dopant, as described in FIG. 8D. The extrinsic base 18 may be single crystalline Si material or SiGe with a constant concentration of Ge.

FIG. 1 further shows an emitter region 26 formed over and in direct contact with a top surface, e.g., lateral surface, of the semiconductor material 16c of the intrinsic base region. In embodiments, the emitter region 26 may be a self-aligned emitter region as described with respect to FIG. 8E. For example, the emitter region 26 directly above the collector region 20 and between the undercut structures 12. In embodiments, the emitter region 26 is laterally within the confines of the collector region 20. The emitter region 26 may be formed by an epitaxial growth process with an in-situ doping process as described herein, e.g., n-type dopant such as Phosphorus (P) or arsenic (A). In embodiments, the bottom of the emitter region 26 is below the undercut 12 and, in further embodiments, above the collector region 20 and the semiconductor material 16c of the intrinsic base region.

Sidewall spacers 28 may be formed on the vertical sidewalls of the emitter region 26, separating or isolating the emitter region 26 from the extrinsic base region 18. The sidewall spacers 28 may be any insulator material, e.g., nitride or oxide based materials, formed by a conventional deposition process, e.g., chemical vapor deposition (CVD) followed by an anisotropic etching process.

It should be understood that, in embodiments, the collector region 20 and the emitter region 26 may be swapped to create, for example, an upside down NPN. It should also be understood that, in embodiments, the collector region 20 and the emitter region 26 may have different aspect ratios to form different devices. For example, the collector region 20 and the emitter region 26 may have larger aspect ratios with the undercut 12 having a smaller aspect ratio to form a power amplifier. In addition, although the figures show the collector region 20 having a larger lateral aspect ratio than the emitter region 26, e.g., the collector region 20 may overlap beyond edges of the emitter region 26, the present disclosure also contemplates the collector region 20 having a smaller lateral aspect ratio than the emitter region 26.

Silicide contacts 30 may be formed on the extrinsic base region 18, the emitter region 26 and the sub-collector region 24. As should be understood by those of skill in the art, the silicide process begins with deposition of a thin transition metal layer, e.g., nickel, cobalt or titanium, over fully formed and patterned semiconductor devices (e.g., extrinsic base region 18, emitter region 26 and sub-collector region 24). After deposition of the material, the structure is heated allowing the transition metal to react with exposed silicon (or other semiconductor material as described herein) in the active regions of the semiconductor device (e.g., extrinsic base region 18, emitter region 32 and sub-collector region 24) forming a low-resistance transition metal silicide. Following the reaction, any remaining transition metal is removed by chemical etching, leaving silicide contacts in the active regions of the device.

Contacts 32 may be formed on the silicide contacts 30. In embodiments, the contacts 32 may be any back end of the line metal. For example, the contacts 32 may be Tungsten, Copper, Aluminum, TiN, etc. In embodiments, the contacts 32 may be formed in additional interlevel dielectric material 14 formed by a deposition process, e.g., conventional chemical vapor deposition (CVD), followed by conventional lithography, etching and deposition methods known to those of skill in the art.

By way of example of forming the contacts 30, a resist formed over the interlevel dielectric material 14 is exposed to energy (light) and developed utilizing a conventional resist developer to form a pattern (e.g., openings). An etching process with a selective chemistry, e.g., reactive ion etching (RIE), will be used to transfer the pattern from the patterned photoresist to the interlevel dielectric material 14, forming trenches in the interlevel dielectric material 14 that expose the silicide contacts 30. Following the resist removal by a conventional oxygen ashing process or other known stripant, conductive material may be deposited in the trenches by any conventional deposition processes, e.g., chemical vapor deposition (CVD) processes. Any residual material on the surface of the interlevel dielectric material 36 can be removed by conventional chemical mechanical polishing (CMP) processes.

FIG. 2 shows a structure in accordance with additional aspects of the present disclosure. In the structure 10a of FIG. 2, the collector region 20a may comprise sloped surfaces 34a at the bottom thereof. In this configuration, the bottom sloped surfaces 34a of the collector region 20 may be lined with the semiconductor material 16b. The remaining features of the structure 10a are similar to the structure 10 of FIG. 1 such that no further explanation is required for a complete understanding of the present disclosure.

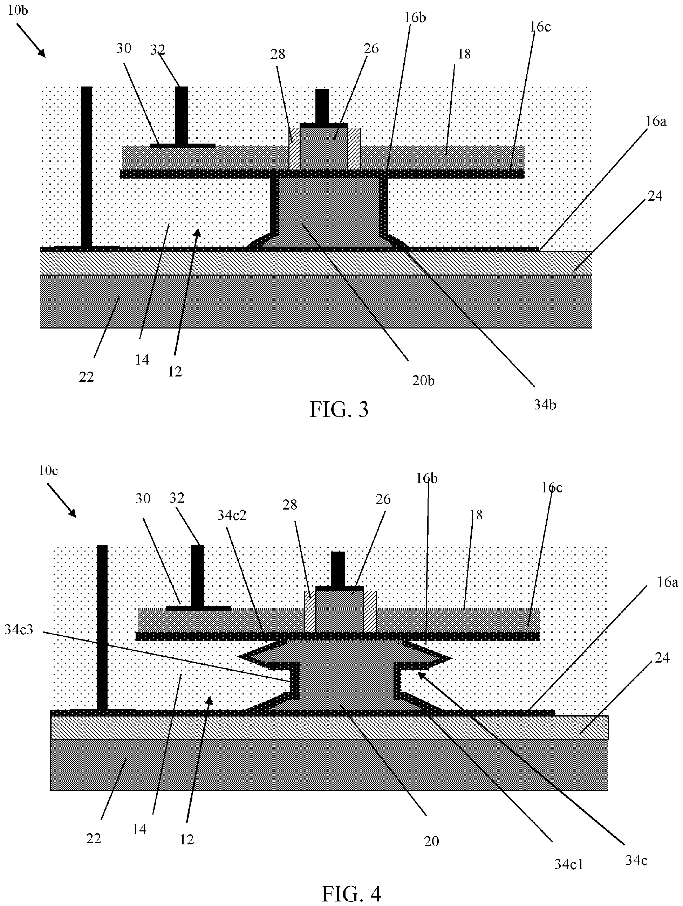

FIG. 3 shows another structure in accordance with additional aspects of the present disclosure. In the structure 10b of FIG. 3, the collector region 20a may comprise rounded or curved surfaces 34b at a bottom thereof. In this configuration, the bottom rounded or curved surfaces 34b of the collector region 20 may be lined with the semiconductor material 16b. The remaining features of the structure 10b are similar to the structure 10 of FIG. 1 such that no further explanation is required for a complete understanding of the present disclosure.

FIG. 4 shows another structure in accordance with additional aspects of the present disclosure. In the structure 10c of FIG. 4, the collector region 20a may comprise still different sidewall configurations depicted generally at reference numeral 34c. In this configuration, the bottom portion may include a rounded, curved or sloped profile as shown at reference numeral 34c1 (similar to the configuration shown in FIGS. 2 or 3), in addition to a double tapered profile at a top portion thereof as shown at reference numeral 34c2 and a straight profile between the top profile and bottom profile as shown at reference numeral 34c3. In embodiments, as with the other embodiments, the profiles may be the result of using different materials and/or selective etching processes. Also, in this configuration, the surfaces of the different profiles 34c1, 34c2, 34c3 of the collector region 20 may be lined with the semiconductor material 16b. The remaining features of the structure 10c are similar to the structure 10 of FIG. 1 such that no further explanation is required for a complete understanding of the present disclosure.

FIG. 5 shows another structure 10d in accordance with aspects of the present disclosure. In the structure 10d of FIG. 5, the undercut region 12 is not filled with any insulator material, resulting in an airgap 14a. Alternatively, the undercut region 12 can be partially filled with insulator material which will result in a smaller airgap 14a. The airgap 14a may be formed by a pinch-off process during the deposition of the interlevel dielectric material 14 as is known to those of skill in the art such that no further explanation is required for a complete understanding of the present disclosure.

In embodiments, the airgap 14a may be bounded laterally and vertically by the interlevel dielectric material 14 and the semiconductor material 16a,16b, 16c. In addition, it should be recognized that the airgap 14a may be used with any of the different configurations of the collector region 20 as shown in FIGS. 1-7. The remaining features of the structure 10d are similar to the structure 10 of FIG. 1 such that no further explanation is required for a complete understanding of the present disclosure.

FIG. 6 shows another structure 10e in accordance with aspects of the present disclosure. In the structure 10e of FIG. 6, plural (e.g., two) collector regions 20, 20a and plural (e.g., two) emitter regions 26, 26a are provided above the sub-collector region 24. As in the structure 10a of FIG. 1, the collector regions 20, 20a may be bounded by the semiconductor materials 16a, 16b, 16c. Accordingly, in this configuration, the collector regions 20, 20a each have sidewalls composed of the semiconductor material 16b, a bottom surface on the semiconductor material 16a and a top surface under the semiconductor material 16c. As to the latter feature, the semiconductor material 16c (e.g., intrinsic base) may be between the collector regions 20, 20a and the emitter regions 26, 26a. The remaining features of the structure 10e are similar to the structure 10 of FIG. 1 such that no further explanation is required for a complete understanding of the present disclosure.

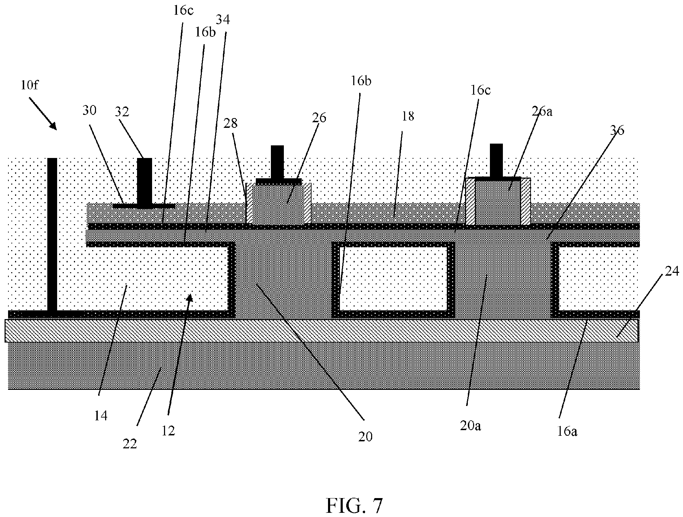

FIG. 7 shows another structure in accordance with aspects of the present disclosure. In the structure 10f of FIG. 7, plural (e.g., two) collector regions 20, 20a and plural (e.g., two) emitter regions 26, 26a are provided above the sub-collector region 24. In the structure 10f, the collector regions 20, 20a are directly on the semiconductor material of sub-collector region 24. In this way, there will be a gap or space between portions of the semiconductor material 16a underneath the collector regions 20, 20a. In addition, an additional layer of semiconductor material 34 may be above the collector regions 20, 20a and below the emitter regions 26, 26a. In this configuration, the semiconductor material 16b which lines the sidewalls of the collector regions 20, 20a may extend underneath the additional layer of semiconductor material 34. On the other hand, the semiconductor material 16c may be above the additional layer of semiconductor material 34, still acting as the intrinsic base. Also, between the collector regions 20, 20a may be insulator material 14 encapsulated by the semiconductor material 16b on the sides, the bottom and the top, with the semiconductor material 16b being on the inner or facing sidewalls of the collector regions 20, 20a. The semiconductor material 34 may be the same material as the semiconductor material of the collector regions 20, 20a. The remaining features of the structure 10f are similar to the structure 10 of FIG. 1 such that no further explanation is required for a complete understanding of the present disclosure.

FIGS. 8A-8L show fabrication processes of a structure in accordance with aspects of the present disclosure. The fabrication processes shown in these figures represent the fabrication of the structure 10 of FIG. 1. It should be recognized by those of skill in the art, though, that similar fabrication processes can be used for the structures shown in FIGS. 2-7. For example, the structure 10a, 10b, 10c shown in FIGS. 2-4 may include different etch chemistries or materials that are selective to form the different configurations in the collector region 20. In FIG. 5, a pinch off process may be used with the deposition of the insulator material 14 to form an airgap. Additionally, in FIGS. 6 and 7, different patterned masks may be used to form multiple collector regions 20, 20a and emitter regions 26, 26a.

In FIG. 8A, for example, the semiconductor substrate 22 undergoes an ion implantation process to form the sub-collector region 24 in the semiconductor substate 22. As already described herein, the ion implantation process provides an n-type dopant into the semiconductor substrate 22. The semiconductor substrate 22 is preferably a single crystalline semiconductor material, e.g., Si, with a suitable crystallographic orientation (e.g., a (100), (110), (111), or (001) crystallographic orientation).

As further shown in FIG. 8A, the semiconductor material 16a (e.g., part of the sub-collector region) may be formed on the semiconductor substrate 22. In embodiments, the semiconductor material 16a may be formed by an epitaxially growth process with an in-situ doping process. In embodiments, the semiconductor material 16a may be an epitaxial growth of single crystalline SiGe material with an n-type dopant, e.g., Arsenic or Phosphorus.

Examples of various epitaxial growth process apparatuses that can be employed in the present disclosure include, e.g., rapid thermal chemical vapor deposition (RTCVD), low-energy plasma deposition (LEPD), ultra-high vacuum chemical vapor deposition (UHVCVD), atmospheric pressure chemical vapor deposition (APCVD) and molecular beam epitaxy (MBE). The epitaxial growth may be performed at a temperature of from 300° C. to 800° C. The epitaxial growth can be performed utilizing any well-known precursor gas or gas mixture. Carrier gases like hydrogen, nitrogen, helium and argon can be used. A dopant (n-type or p-type, as defined below) is typically added to the precursor gas or gas mixture for the in-situ processes.

Still referring to FIG. 8A, a semiconductor material 40 may be formed over the semiconductor material 16a. In embodiments, the semiconductor material 40 should be a semiconductor material that is selectively etchable with respect to the semiconductor material 16a. In preferred embodiments, the semiconductor material 40 may be undoped Si material. Other semiconductor materials may also be used for the semiconductor material 40, which have different etch selectivity's, e.g., different concentrations of Ge% at different layers or different materials at different layers, to form different collector configurations. A trench 42 is formed in the semiconductor material 40 and terminating over or slightly within the semiconductor material 16a, using conventional lithography and etching processes, e.g., RIE, as already described herein.

In FIG. 8B, the semiconductor material 16b may be formed on the sidewalls and bottom of in the trench 42 and over the semiconductor material 40. The semiconductor material 16b may be formed by an epitaxial growth process with an in-situ doping. For example, the semiconductor material 16b may be SiGe with a n-type dopant, e.g., Phosphorus (SiGeP). In other embodiments, the semiconductor material 16b may be undoped or SiC material as examples. The semiconductor material used for the collector region 20 may be formed over the semiconductor material 16b and within the trench 42. The semiconductor material 20 may be, for example, formed by an epitaxial growth process with an n-type in situ doping process, e.g., SiGeP.

In FIG. 8C, the semiconductor material 16b and the semiconductor material 20 may be subjected to a chemical mechanical polishing (CMP). The CMP will remove the semiconductor material 16b above the trench 42, leaving the semiconductor material 16b on the vertical sidewalls of the trench 42. The semiconductor material 20 will also be removed above the trench 42, leaving the semiconductor material 20 within the trench 42. In this way, the semiconductor material 20 can be used to form the collector region, with the semiconductor material 16a underneath and the semiconductor material 16b on sidewalls of the collector region 20.

In FIG. 8D, the semiconductor material 16c (e.g., intrinsic base region) may be formed on the semiconductor material 20 and the semiconductor material 40. In this way, the semiconductor material 16a, 16b, 16c now encapsulates the collector region 20. The semiconductor material 16c may be epitaxially grown with an p-type in-situ doping process, e.g., SiGeB. Also, it should be recognized by one of ordinary skill in the art, the semiconductor material 20 may be selective to the semiconductor materials 16a, 16b, 16c.

FIG. 8D further shows the semiconductor material 26 (used to form the emitter region) formed on the semiconductor material 16c. The semiconductor material 26 may be epitaxially grown on the semiconductor material 16c with an n-type in-situ doping process, e.g., SiP or SiA. Although not shown, a capping material (e.g., nitride) may be formed over the semiconductor material 26 using conventional deposition processes, e.g., chemical vapor deposition (CVD),

As further shown in FIG. 8E, the semiconductor material 26 may be patterned using conventional lithography and etching processes, e.g., RIE, to form the emitter region. Thereafter, the sidewall spacers 28 may be formed on the patterned emitter region 26. In embodiments, the sidewall spacers 28 may be formed by a deposition of oxide material, nitride material or combinations thereof, followed by a conventional anisotropic etching process. The semiconductor material of the extrinsic base region 18 may be formed on the sides of the emitter region 26. In embodiments, the semiconductor material of the extrinsic base region 18 may be epitaxially grown over the semiconductor material 16c of the intrinsic base region and the emitter region 26, followed by a CMP process.

In FIG. 8F, the structure is subjected to an etching process to pattern the semiconductor material of the extrinsic base region 18, the semiconductor material 16c of the intrinsic base region, in addition to portions of the semiconductor material 40 over the semiconductor material 16a of the sub-collector region 24. In embodiments, the patterning can be performed by conventional lithography and etching processes, with a mask protecting the emitter region 26 and portions of the extrinsic base region 18 and intrinsic base region 16c. Etch chemistries with different selectivity can be used for the removal of the different materials. In these processes, the underlying semiconductor material 16a and portions of the semiconductor material 40 between the semiconductor material 16a, 16c may be exposed.

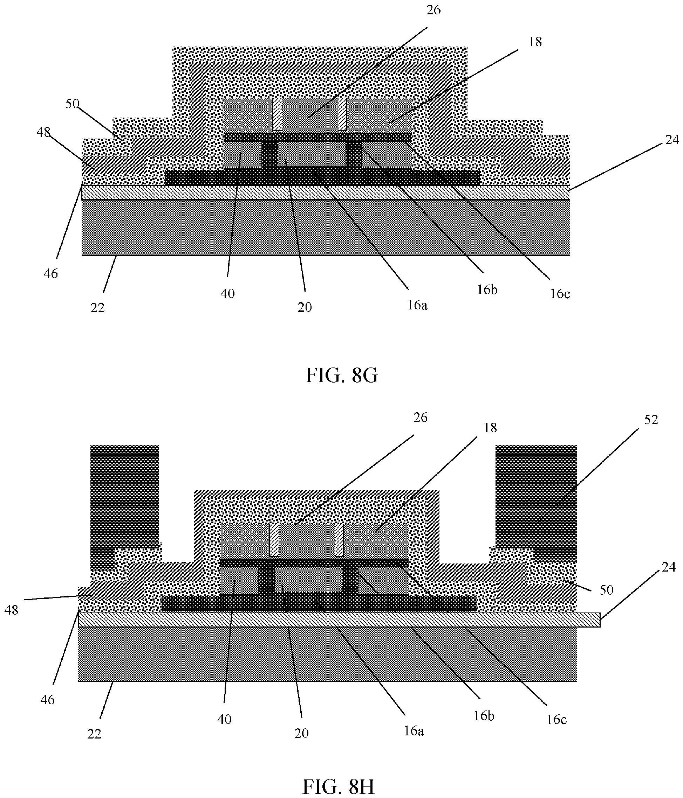

As further shown in FIG. 8G, exposed portions of the semiconductor material 16c may be removed using a selective etch chemistry. Masking layers 46, 48, 50 may be formed over the exposed portions of the semiconductor substrate 22, the semiconductor material 40, the semiconductor material 16a, 16c, the extrinsic base region 18 and the emitter region 26. In embodiments, the material for the masking layers 46, 50 are different than the material for masking layer 48. For example, the masking layers 46, 50 may be oxide material and the material for masking layer 48 may be nitride material. In this way, it will be possible to etch portions of each of the layers selectively with respect to other layers without the need for additional masking materials.

By way of example, as shown in FIG. 8H, a masking layer 52 may be deposited and patterned over the asking layer 50. In embodiments, the masking layer 52 may be any appropriate resist material(s) used in conventional lithography and etching processes. In the process, a pattern of the masking layer 52 may be laterally beyond outer edges of the semiconductor material 40. In the subsequent etching process, portions of the masking layer 50 that are exposed by the patterned masking layer 52 may be removed by a conventional RIE process. This etching process will expose portions of the masking layer 48.

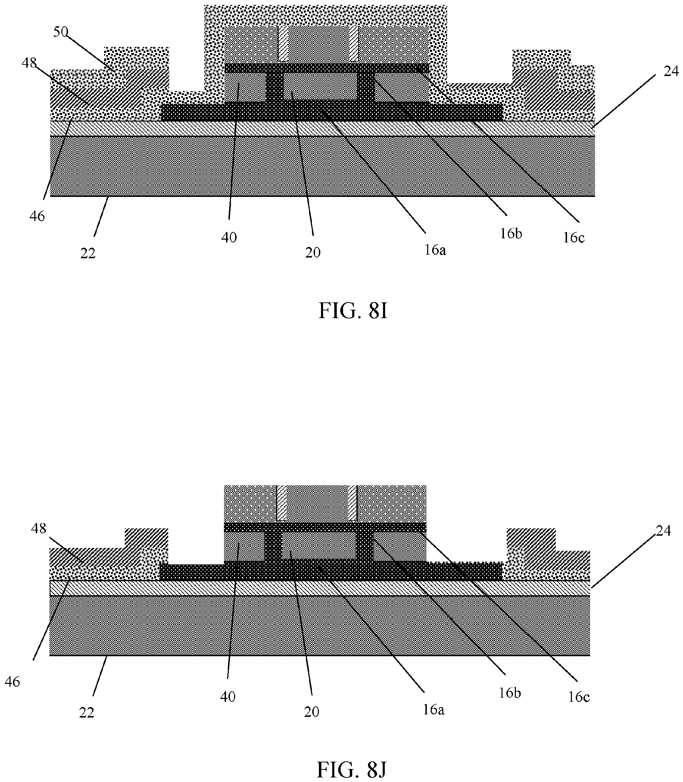

In FIG. 8I, the masking layer 52 may be removed by conventional processes such as known stripants or oxygen ashing processes. This will expose the remaining portions of the masking layer 50 and the underlying exposed portion of the masking layer 48. In embodiments, the exposed masking layer 48 may be removed by a selective chemistry, with the masking layer 50 protecting the remaining portions of the structure. The removal of the masking layer 48 will expose the underlying masking layer 46, allowing for additional selective removal of materials, e.g., making layer 46.

In FIG. 8J, the exposed portion of the masking layers 48, 50 may be removed using a conventional selective etch chemistry. The etching process will stop on the semiconductor material 16a. In addition, the etching process will expose portions of the semiconductor material 40.

In FIG. 8K, the exposed semiconductor material 40 can be removed using a conventional selective etch chemistry. In this way, an undercut 12 may be formed between the semiconductor materials 16a, 16b, 16c and adjacent to the collector region 20. The etching chemistry should not attack or remove the semiconductor materials 16a, 16b, 16c, as they are different materials than the semiconductor material 40.

In FIG. 8J, the undercut 12 can be filled with an insulator material 14. For example, the insulator material 14 may be an oxide material and, more preferably, TEOS. The insulator material 14 may be blanket deposited on the structure with a subsequent etching process to remove any excess insulator material. The processes continue at FIG. 1, for example, with deposition of additional interlevel dielectric material, followed by the formation of silicide contacts and contacts to the extrinsic base region 18, the emitter region 26 and the sub-collector region 16a, 24.

The structures can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multichip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
a collector region above a semiconductor substrate;
a base region above the collector region;
an emitter region adjacent to the base region; and
an undercut structure above the semiconductor substrate and adjacent to the collector region.

2. The structure of claim 1, wherein the undercut structure is filled with insulator material, or wherein the undercut structure comprises an airgap.

3. The structure of claim 2, wherein the insulator material is flowable oxide.

4. The structure of one of claims 1 to 3, wherein the undercut structure is bounded laterally and vertically by a semiconductor material comprising an intrinsic base, a liner on vertical sidewalls of the collector region, and a portion of a sub-collector region.

5. The structure of claim 4, wherein the collector region comprises Si material and the semiconductor material, the liner and the portion of the sub-collector comprise SiGe material, and, optionally, wherein the structure further comprises a remaining portion of the sub-collector region within the semiconductor substrate which comprises doped Si material.

6. The structure of one of claims 1 to 5, wherein the base region comprises an intrinsic base separating the collector region from the emitter region and an extrinsic base region above the intrinsic base region and adjacent to the emitter region.

7. The structure of one of claims 1 to 6, wherein the collector region comprises at least one of a sloped bottom surface, a curved bottom surface and a double tapered upper portion, and/or wherein the collector region has a lateral dimension larger than the emitter region such that the undercut structure is on a side of emitter region.

8. The structure of one of claims 1 to 7, further comprising a second collector region and a second emitter region, and wherein the undercut structure comprises insulator material between the collector region and the second collector region which is encapsulated by an intrinsic base region, a portion of a sub-collector region and semiconductor material on facing sidewalls of the collector region and second collector region.

9. The structure of one of claims 1 to 7, further comprising a second collector region and a second emitter region, wherein the undercut structure comprises insulator material between the collector region and the second collector region which is encapsulated by a part of a sub-collector region and semiconductor material on facing sidewalls of the collector region and second collector region and a top surface of the insulator material, and wherein the semiconductor material on the top surface of insulator material is separated from the base region by additional semiconductor material.

10. A structure comprising:
a heterojunction bipolar transistor comprising a base region, a collector region, a sub-collector region and an emitter region; and
an undercut region bounded on a lateral surface and a vertical surface by the base region, and semiconductor material lining vertical sidewalls of the collector region and of the sub-collector region.

11. The structure of claim 10, wherein the base region comprises an intrinsic base region on an upper portion of the collector region and an extrinsic base region adjacent to the emitter region, and/or wherein the collector region is encapsulated by semiconductor material of the base region at an upper portion, semiconductor material of the sub-collector region at a bottom portion and semiconductor material on vertical sidewalls of the collector region.

12. The structure of claim 10 or claim 11, wherein the undercut region is filled with insulator material.

13. The structure of one of claims 10 to 12, wherein the collector region comprises at least one of a sloped bottom surface, a curved bottom surface and a double tapered upper portion, and/or wherein the collector region comprises Si material bounded by SiGe material.

14. The structure of one of claims 10 to 13, wherein the heterojunction bipolar transistor comprises a second collector region and a second emitter region, wherein the undercut region is provided between the collector region and the second collector region, and which comprises insulator material encapsulated by a semiconductor lining material.

15. A method comprising:
forming a collector region above a semiconductor substrate;
forming a base region above the collector region;
forming an emitter region adjacent to the base region; and
forming an undercut structure above the semiconductor substrate and adjacent to the collector region.
